# EUROPÄISCHE PATENTSCHRIFT

(11) **EP 3 320 591 B1**
(45) Veröffentlichungstag und Bekanntmachung des Hinweises auf die Patenterteilung: **09.09.2020**
(21) Anmeldenummer: 16738115.1
(22) Anmeldetag: 07.07.2016
(51) Int. Cl.: H02H 3/33, H02H 1/00, G01R 19/10

(54) **FEHLERSTROMSENSOR FÜR EINE FEHLERSTROM-SCHUTZEINRICHTUNG ZUM ÜBERWACHEN EINES ELEKTRISCHEN VERBRAUCHERS FÜR EIN FAHRZEUG**
FAULT CURRENT SENSOR FOR A FAULT CURRENT PROTECTION DEVICE FOR MONITORING AN ELECTRICAL CONSUMER FOR A VEHICLE
DÉTECTEUR DE COURANT DE FUITE POUR DISPOSITIF DE PROTECTION CONTRE UN COURANT DE FUITE DESTINÉ À LA SURVEILLANCE D'UN CONSOMMATEUR ÉLECTRIQUE POUR UN VÉHICULE

(30) Priorität: 08.07.2015 DE 102015008699
(43) Veröffentlichungstag der Anmeldung: 16.05.2018
(73) Patentinhaber: JENOPTIK Advanced Systems GmbH, 22880 Wedel (DE)
(72) Erfinder: SEIDLER, Klaus, 25436 Uetersen (DE)
(74) Vertreter: Waldauf, Alexander
(86) Internationale Anmeldenummer: PCT/EP2016/066145
(87) Internationale Veröffentlichungsnummer: WO 2017/005858

(56) Entgegenhaltungen:
- US-A1- 2006 119 368
- US-A1- 2014 009 299

## Beschreibung

### Stand der Technik

Die vorliegende Erfindung bezieht sich auf einen Fehlerstromsensor für eine Fehlerstrom-Schutzeinrichtung zum Überwachen eines elektrischen Verbrauchers für ein Fahrzeug, auf eine Fehlerstrom-Schutzeinrichtung zum Überwachen eines elektrischen Verbrauchers für ein Fahrzeug, auf ein Verfahren zum Bestimmen eines Fehlerstroms eines elektrischen Verbrauchers für ein Fahrzeug sowie auf ein entsprechendes Computerprogrammprodukt.

In der industriellen Technik und der Haustechnik können Fehlerstromschalter eingesetzt werden, die je nach Auslegung bei Erreichen eines Fehlerstromwertes einen angeschlossenen Verbraucher mehrpolig abschalten und damit vollständig von einer Versorgung abtrennen können. Solche Komponenten können manuell oder auch ferngesteuert wieder eingeschaltet werden. Bei solchen Anwendungen können zu überwachende Komponenten üblicherweise vollständig über elektrische Leitungen angeschlossen sein.

Die EP 2 020 014A1 betrifft eine Schalteinrichtung, wie beispielsweise einen Fehlerstromschutzschalter oder Kombischalter, zum Unterbrechen und Schalten zumindest einer Leitung. Die US 2014/009299 A1 offenbart einen Fehlerstromsensor, eine Differentialstrommessvorrichtung und eine Meldevorrichtung. Ein Prozessor vergleicht den gemessenen Differentialstrom mit einem Schwellenwert und veranlasst ggf., dass die Meldevorrichtung einen Fehlerstrom über die Stromleitung meldet. Die US 2006/119368 A1 offenbart einen Fehlerstromsensor, wobei die Kommunikation zwischen den Sensoren und einer Central-Station über eine Stromleitung erfolgt, wobei dazu eine Analogmodulation verwendet wird.

### Offenbarung der Erfindung

Vor diesem Hintergrund wird mit der vorliegenden Erfindung ein Fehlerstromsensor für eine Fehlerstrom-Schutzeinrichtung zum Überwachen eines elektrischen Verbrauchers für ein Fahrzeug vorgestellt. Vorteilhafte Ausgestaltungen ergeben sich aus den jeweiligen Unteransprüchen und der nachfolgenden Beschreibung.

Gemäß Ausführungsformen der vorliegenden Erfindung kann ein abgesetzter Fehlerstromsensor für einen Controller eines elektrischen Verbrauchers bereitgestellt werden, wobei beispielsweise Stromrückleitungen über geerdete Strukturen genutzt werden können. Anders ausgedrückt kann beispielsweise ein abgesetzter Fehlerstromsensor für einen Heizercontroller für einen Einsatz in Luftfahrzeugen bereitgestellt und somit ein Heizercontroller mit abgesetztem Fehlerstromsensor für den Einsatz in Luftfahrzeugen realisiert werden. Es kann somit eine schaltungsmäßige Lösung zum Überwachen eines elektrischen Verbrauchers auf ein Auftreten eines Fehlerstromes unter Beachtung oder Berücksichtigung einer Stromrückführung über eine geerdete Struktur oder über Sammelleiter realisiert werden. Dabei ist auch eine schwer zugängliche Einbaulage einer solchen Schutzkomponente realisierbar.

Vorteilhafterweise kann gemäß Ausführungsformen der vorliegenden Erfindung ein kostengünstiger und zuverlässiger Fehlerstromschutz für elektrische Verbraucher in Fahrzeugen, insbesondere in Fahrzeugen mit schwer zugänglichen Einbauorten für elektrische Verbraucher und Schutzeinrichtungen, bereitgestellt werden. Speziell bezogen auf eine Anwendung in Luftfahrzeugen oder in der Luftfahrt kann eine Überwachung von elektrischen Verbrauchern, insbesondere von beheizten Komponenten, auf auftretenden Fehlerstrom realisiert werden. Bei beheizten Komponenten kann dies durch eine Erweiterung einer Heizercontrollerfunktion erfolgen. Hierbei können Funktionen oder Fähigkeiten einer bereits vorhandenen Steuervorrichtung, insbesondere eines bereits vorhandenen Heizercontrollers genutzt werden, wobei eine Ausgangsstrombewertungslogik beispielsweise auch in Form von Software vorgesehen werden kann. Der vorgeschlagene Fehlerstromsensor kann eine einfache, robuste und kostengünstige Schaltung repräsentieren, die ohne zusätzliche Verdrahtung vor eine zu schützende, insbesondere beheizte, Komponente eingebaut werden kann.

Somit kann ein Fehlerstromschutz unter Vermeidung zusätzlichen Verdrahtungsaufwands oder einer Verdrahtungsänderung erreicht werden, was insbesondere auch bei Luftfahrzeugen eine hinsichtlich Wirtschaftlichkeitserwägungen vorteilhafte Gewichtseinsparung beispielsweise im Vergleich zu einem zusätzlichen Fehlerstromschalter ermöglichen kann. Bezogen auf eine Anwendung in der Luftfahrt können Ausführungsformen der vorliegenden Erfindung auch als kostengünstige, zuverlässige und Platz sowie Gewicht sparende Alternativen zu manuell rücksetzbaren Fehlerstromschaltern oder auch zu ferngesteuerten, wieder einschaltbaren Fehlerstromschaltern eingesetzt werden. Dies ist vorteilhaft, da manuell rücksetzbare Fehlerstromschalter in der Regel unter Berücksichtigung einer gebräuchlichen elektrischen Anschlusstechnik unzweckmäßig sind, da sie direkt an einer zu überwachenden Komponente zu installieren und damit kaum zugänglich sind. Ferngesteuerten, wieder einschaltbare Fehlerstromschalter sind aufwendige Komponenten, die zudem zusätzliche Verbindungen und Einrichtungen zum ferngesteuerten Rücksetzen erfordern können. Im Vergleich dazu kann unter Verwendung des beschriebenen Ansatzes eine Betriebssicherheit von zu überwachenden elektrischen Verbrauchern mit reduziertem Aufwand erhöht werden.

Es wird ein Fehlerstromsensor für eine Fehlerstrom-Schutzeinrichtung zum Überwachen eines elektrischen Verbrauchers für ein Fahrzeug vorgestellt, wobei der Fehlerstromsensor folgende Merkmale aufweist:
eine Messvorrichtung zum Messen eines Differenzstroms zwischen einem ersten elektrischen Strom in einem elektrischen Hinleiter, der von einer Steuervorrichtung zum Steuern des elektrischen Verbrauchers zu dem elektrischen Verbraucher hinleitet, und einem zweiten elektrischen Strom in einem elektrischen Rückleiter, der von dem elektrischen Verbraucher wegleitet; und
eine Meldevorrichtung zum Melden eines Fehlerstroms an die Steuervorrichtung über den Hinleiter abhängig von einem Vergleich des gemessenen Differenzstroms mit einem Schwellenwert.

Der Fehlerstromsensor und die Steuervorrichtung können Teile der Fehlerstrom-Schutzeinrichtung sein. Die Fehlerstrom-Schutzeinrichtung kann als ein sogenannter Fl-Schalter oder Fehlerstromschutzschalter bezeichnet werden. Dabei kann der Fehlerstromsensor, wie auch die Fehlerstrom-Schutzeinrichtung, insbesondere in einem Kraftfahrzeug, beispielsweise in einem Luftfahrzeug, eingesetzt werden. Der elektrische Verbraucher kann zum Beispiel als ein Heizer oder eine andere Last ausgeführt sein. Der Fehlerstromsensor kann elektrisch zwischen die Steuervorrichtung und den elektrischen Verbraucher geschaltet sein. Die Fehlerstrom-Schutzeinrichtung kann beispielsweise auch zum Überwachen einer Mehrzahl von elektrischen Verbrauchern ausgebildet oder vorgesehen sein.

Gemäß einer Ausführungsform kann die Meldevorrichtung ausgebildet sein, um den Fehlerstrom unter Verwendung einer Stromamplitudenmodulation auf dem Hinleiter an die Steuervorrichtung zu melden. Eine solche Ausführungsform bietet den Vorteil, dass ein vorliegender Fehlerstrom einfach, zuverlässig und unaufwendig berichtet werden kann.

Ferner kann die Meldevorrichtung einen Schalter zum Lastumschalten und eine definierte Last aufweisen. Hierbei kann die definierte Last mit dem Rückleiter elektrisch leitend verbunden sein. Dabei kann der Schalter ausgebildet sein, um in einer geöffneten Schaltstellung den Hinleiter zu dem elektrischen Verbraucher hin zu unterbrechen und mit der definierten Last zu verbinden. Ein Strom durch die definierte Last kann unterhalb eines Bereiches liegen, der einen Versorgungsstrombereich des elektrischen Verbrauchers repräsentiert, und kann durch die Steuervorrichtung als Auftreten eines erkannten Fehlerstromes interpretierbar sein. Eine solche Ausführungsform bietet den Vorteil, dass ein Fehlerstromfall sicher und unkompliziert gemeldet werden kann.

Auch kann die Meldevorrichtung einen Schalter zum Zuschalten einer definierten Last aufweisen. Hierbei kann die definierte Last mit dem Rückleiter elektrisch leitend verbunden sein. Der Schalter kann ausgebildet sein, um in einer geschlossenen Schaltstellung die definierte Last mit dem Hinleiter zu verbinden. Somit kann die Last eingeschaltet bleiben. Ein sich ergebender Summenstrom aus einem Laststrom und einem Strom der definierten Last kann oberhalb eines Bereiches liegen, der einen Versorgungsstrombereich des elektrischen Verbrauchers repräsentiert, und kann durch die Steuervorrichtung als Auftreten eines erkannten Fehlerstromes interpretierbar sein. Eine solche Ausführungsform bietet den Vorteil, dass ein Fehlerstromfall sicher und unkompliziert gemeldet werden kann.

Zudem kann die Meldevorrichtung einen Schalter zum Lastabschalten aufweisen. Hierbei kann der Schalter ausgebildet sein, um in einer geöffneten Schaltstellung den Hinleiter zu dem elektrischen Verbraucher zu unterbrechen. Eine solche Ausführungsform bietet den Vorteil, dass ein erfasster Fehlerstrom schnell und zuverlässig mitgeteilt werden kann.

Auch kann die Meldevorrichtung ausgebildet sein, um den Fehlerstrom durch Aufmodulieren eines hochfrequenten Datensignals auf den Hinleiter an die Steuervorrichtung zu melden. Eine solche Ausführungsform bietet den Vorteil, dass unter Verwendung einer Trägerfrequenztechnik ein Vorliegen eines Fehlerstroms sicher und kostengünstig gemeldet werden kann.

Gemäß einer Ausführungsform kann der Fehlerstromsensor eine elektrische Schaltung zum Durchführen des Vergleichs des gemessenen Differenzstroms mit einem Schwellenwert aufweisen. Die elektrische Schaltung kann ausgebildet sein, um den Vergleich des gemessenen Differenzstroms mit einem Schwellenwert durchzuführen. Optional kann die elektrische Schaltung zusätzlich ausgebildet sein, um weitere Funktionen für den Fehlerstromsensor auszuführen. Eine solche Ausführungsform bietet den Vorteil, dass schnell und sicher festgestellt werden kann, ob ein Fehlerstromfall gegeben ist.

Es wird auch eine Fehlerstrom-Schutzeinrichtung zum Überwachen eines elektrischen Verbrauchers für ein Fahrzeug vorgestellt, wobei die Fehlerstrom-Schutzeinrichtung folgende Merkmale aufweist:
eine Ausführungsform des vorstehend genannten Fehlerstromsensors; und
eine Steuervorrichtung zum Steuern des elektrischen Verbrauchers, wobei die Steuervorrichtung und der Fehlerstromsensor zumindest mittels des Hinleiters miteinander elektrisch leitend verbindbar oder verbunden sind.

In Verbindung mit der Fehlerstrom-Schutzeinrichtung kann eine Ausführungsform des vorstehend genannten Fehlerstromsensors vorteilhaft eingesetzt oder verwendet werden, einen Fehlerstrom hinsichtlich des elektrischen Verbrauchers zu erkennen oder zu erfassen. Die Steuervorrichtung kann ausgebildet sein, um einen elektrischen Stromfluss durch den elektrischen Verbraucher in Abhängigkeit von einem gemeldeten Fehlerstrom zu unterbrechen.

Gemäß einer Ausführungsform können die Steuervorrichtung und der Fehlerstromsensor getrennt voneinander eingehaust sein. Hierbei kann der Fehlerstromsensor außerhalb eines Gehäuses der Steuervorrichtung angeordnet sein. Anders ausgedrückt kann ein Gehäuse der Steuervorrichtung und ein Gehäuse des Fehlerstromsensor getrennt voneinander angeordnet sein. Eine solche Ausführungsform bietet den Vorteil, dass insbesondere auch bei Stromrückführung von dem elektrischen Verbraucher in einer Teilstrecke über eine geerdete Komponente ein Fehlerstrom hinsichtlich des elektrischen Verbrauchers zuverlässig erkannt werden kann.

Auch kann der Fehlerstromsensor einen Hinleiter-Eingangsanschluss zum Anschluss an einen steuervorrichtungsseitigen Abschnitt des Hinleiters, einen Hinleiter-Ausgangsanschluss zum Anschluss an einen verbraucherseitigen Abschnitt des Hinleiters, einen Rückleiter-Eingangsanschluss zum Anschluss an einen verbraucherseitigen Abschnitt des Rückleiters und einen Rückleiter-Ausgangsanschluss zum Anschluss an einen strukturseitigen Abschnitt des Rückleiters aufweisen. Der steuervorrichtungsseitige Abschnitt des Hinleiters repräsentiert einen Teilabschnitt des Hinleiters, mittels dessen der Fehlerstromsensor und die Steuervorrichtung elektrisch leitend miteinander verbindbar oder verbunden sind. Der verbraucherseitige Abschnitt des Hinleiters repräsentiert einen Teilabschnitt des Hinleiters, mittels dessen der Fehlerstromsensor und der elektrische Verbraucher elektrisch leitend miteinander verbindbar oder verbunden sind. Der verbraucherseitige Abschnitt des Rückleiters repräsentiert einen Teilabschnitt des Rückleiters, mittels dessen der Fehlerstromsensor und der elektrische Verbraucher elektrisch leitend miteinander verbindbar oder verbunden sind. Der strukturseitige Abschnitt des Rückleiters repräsentiert einen Teilabschnitt des Rückleiters, mittels dessen der Fehlerstromsensor über ein Strukturelement des Fahrzeugs mit der Steuervorrichtung verbindbar oder verbunden ist. Eine solche Ausführungsform bietet den Vorteil, dass der Fehlerstromsensor auf einfache und unaufwendige Weise von der Steuervorrichtung abgesetzt angeordnet sein oder werden kann.

Dabei kann der steuervorrichtungsseitige Abschnitt des Hinleiters zumindest so lang sein wie der verbraucherseitige Abschnitt des Hinleiters. Somit kann der Fehlerstromsensor um einen größeren Abstand von der Steuervorrichtung beabstandet sein als von dem elektrischen Verbraucher. Eine solche Ausführungsform bietet den Vorteil, dass ein Fehlerstrom auch bei Stromrückführung über eine geerdete Fahrzeugstruktur sicher und verbrauchernah ermittelt werden kann.

Insbesondere kann die Steuervorrichtung zumindest einen Ausgangsanschluss zum Anschluss an den steuervorrichtungsseitigen Abschnitt des Hinleiters und einen Eingangsanschluss zum Anschluss an einen weiteren strukturseitigen Abschnitt des Rückleiters aufweisen. Hierbei können der weitere strukturseitige Abschnitt und der strukturseitige Abschnitt des Rückleiters über ein Strukturelement des Fahrzeugs elektrisch leitend miteinander verbindbar oder verbunden sein. Dabei kann das Strukturelement geerdet sein und aus einem elektrischen allfälligen Material ausgeformt sein. Die Steuervorrichtung kann auch weitere Anschlüsse zum Anschluss an eine elektrische Spannungsquelle oder Stromquelle aufweisen. Eine solche Ausführungsform bietet den Vorteil, dass eine Platz und Gewicht sparende Realisierung der Fehlerstrom-Schutzeinrichtung sowie der Verschaltung oder Verdrahtung derselben sowie des elektrischen Verbrauchers ermöglicht werden kann.

Zudem kann die Steuervorrichtung eine elektrische Auswerteschaltung zum Auswerten des von dem Fehlerstromsensor gemeldeten Fehlerstroms aufweisen. Hierbei kann die Auswerteschaltung ausgebildet sein, um den von dem Fehlerstromsensor durch Stromamplitudenmodulation oder Aufmodulieren eines hochfrequenten Datensignals gemeldeten Fehlerstrom auszuwerten. Eine solche Ausführungsform bietet den Vorteil, dass auf einen erkannten und gemeldeten Fehlerstrom zuverlässig und schnell in geeigneter Weise reagiert werden kann.

Es wird ferner ein Verfahren zum Bestimmen eines Fehlerstroms eines elektrischen Verbrauchers für ein Fahrzeug vorgestellt, wobei das Verfahren folgende Schritte aufweist:
Messen eines Differenzstroms zwischen einem ersten elektrischen Strom in einem elektrischen Hinleiter, der von einer Steuervorrichtung zum Steuern des elektrischen Verbrauchers zu dem elektrischen Verbraucher hinleitet, und einem zweiten elektrischen Strom in einem elektrischen Rückleiter, der von dem elektrischen Verbraucher wegleitet; und
Melden eines Fehlerstroms an die Steuervorrichtung über den Hinleiter abhängig von einem Vergleich des gemessenen Differenzstroms mit einem Schwellenwert.

Das Verfahren kann in Verbindung mit oder unter Verwendung von einer Ausführungsform des vorstehend genannten Fehlerstromsensors oder auch der vorstehend genannten Fehlerstrom-Schutzeinrichtung vorteilhaft ausgeführt werden.

Es wird ferner eine Vorrichtung vorgestellt, die ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form einer Vorrichtung kann die der Erfindung zugrunde liegende Aufgabe schnell und effizient gelöst werden.

Die Vorrichtung kann ausgebildet sein, um Eingangssignale einzulesen und unter Verwendung der Eingangssignale Ausgangssignale zu bestimmen und bereitzustellen. Ein Eingangssignal kann beispielsweise ein über eine Eingangsschnittstelle der Vorrichtung einlesbares Sensorsignal darstellen. Ein Ausgangssignal kann ein Steuersignal oder ein Datensignal darstellen, das an einer Ausgangsschnittstelle der Vorrichtung bereitgestellt werden kann. Die Vorrichtung kann ausgebildet sein, um die Ausgangssignale unter Verwendung einer in Hardware oder Software umgesetzten Verarbeitungsvorschrift zu bestimmen. Beispielsweise kann die Vorrichtung dazu eine Logikschaltung, einen integrierten Schaltkreis oder ein Softwaremodul umfassen und beispielsweise als ein diskretes Bauelement realisiert sein oder von einem diskreten Bauelement umfasst sein.

Von Vorteil ist auch ein Computer-Programmprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann. Wird das Programmprodukt oder Programm auf einem Computer oder einer Vorrichtung ausgeführt, so kann das Programmprodukt oder Programm zur Durchführung, Umsetzung und/oder Ansteuerung der Schritte des Verfahrens nach einer der vorstehend beschriebenen Ausführungsformen verwendet werden.

Die Erfindung wird nachstehend anhand der beigefügten Zeichnungen beispielhaft näher erläutert. Es zeigen:
Fig. 1 eine schematische Darstellung einer Heizersteuervorrichtung und einer beheizten Komponente;
Fig. 2 eine schematische Darstellung der beheizten Komponente aus Fig. 1;
Fig. 3 eine schematische Darstellung eines Fahrzeugs mit einer Fehlerstrom-Schutzeinrichtung gemäß einem Ausführungsbeispiel der vorliegenden Erfindung;
Fig. 4 eine schematische Darstellung einer Fehlerstrom-Schutzeinrichtung gemäß einem Ausführungsbeispiel der vorliegenden Erfindung und eines elektrischen Verbrauchers für ein Fahrzeug;
Fig. 5A eine schematische Darstellung eines Fehlerstromsensors für eine Fehlerstrom-Schutzeinrichtung gemäß einem Ausführungsbeispiel der vorliegenden Erfindung;
Fig. 5B eine schematische Darstellung eines Fehlerstromsensors für eine Fehlerstrom-Schutzeinrichtung gemäß einem Ausführungsbeispiel der vorliegenden Erfindung;
Fig. 6 eine schematische Darstellung eines Fehlerstromsensors für eine Fehlerstrom-Schutzeinrichtung gemäß einem Ausführungsbeispiel der vorliegenden Erfindung; und
Fig. 7 ein Ablaufdiagramm eines Verfahrens gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

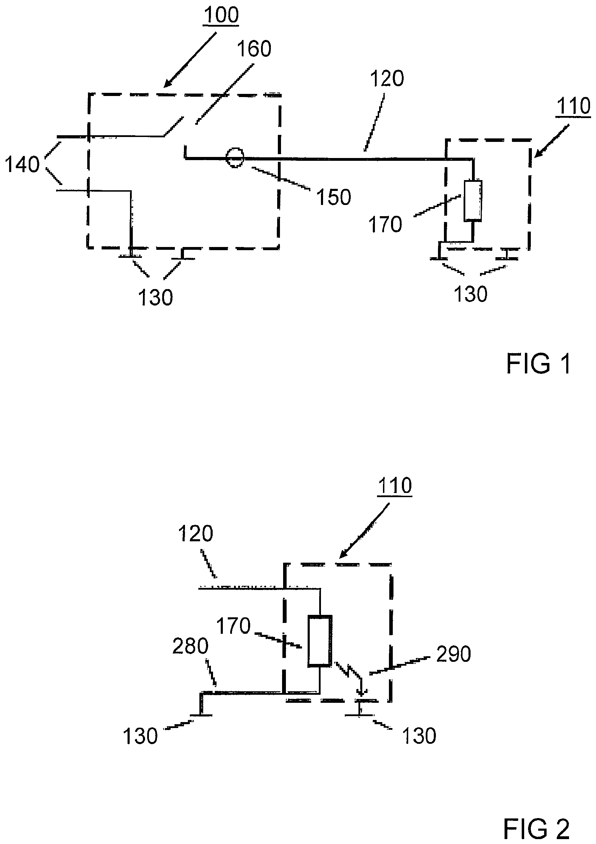

Fig. 1 zeigt eine schematische Darstellung einer Heizersteuervorrichtung 100 bzw. eines Heizercontrollers 100 und einer beheizten Komponente 110. Heizercontroller 100 werden beispielsweise in Flugzeugen zur Überwachung und zur leistungsmäßigen Ansteuerung beheizter Komponenten 110, wie Fußbodenplatten oder Wasserrohre, eingesetzt. Ein elektrischer Anschluss zwischen dem Heizercontroller 100 und der beheizten Komponente 110 erfolgt in Flugzeugen üblicherweise einpolig über einen Hinleiter 120. Eine Rückleitung des elektrischen Stromes von der beheizten Komponente 110 zu dem Heizercontroller 100 erfolgt durch einen Strukturanschluss 130 bzw. Anschluss über eine Struktur. Alternativ kann die Rückleitung auch über Sammelleitungen erfolgen.

Hierbei weisen sowohl der Heizercontroller 100 als auch die beheizte Komponente 110 zumindest einen Strukturanschluss 130 auf. In der Darstellung von Fig. 1 weisen sowohl der Heizercontroller 100 als auch die beheizte Komponente 110 jeweils zwei Strukturanschlüsse 130 auf. Der Heizercontroller 100 weist ferner Versorgungsanschlüsse 140 für eine Versorgungsspannung des Heizercontrollers 100 auf. Zudem weist der Heizercontroller 100 einen Stromsensor 150 und einen Ausgangsschalter 160 auf. Die beheizte Komponente 110 weist einen Heizer 170 auf, der einen elektrischen Verbraucher repräsentiert.

Fig. 2 zeigt eine schematische Darstellung der beheizten Komponente 110 aus Fig. 1. Hierbei sind in Fig. 2 der Hinleiter 120 und von der beheizten Komponente 110 die Strukturanschlüsse 130, der Heizer 170 sowie ein Rückleiter 280 und symbolisch ein Fehlerstrom 290 gezeigt. Der Rückleiter 280 erstreckt sich dabei von dem Heizer 170 zu einem der Strukturanschlüsse 130.

Durch mechanische Beschädigung und oder durch Eindringen von Flüssigkeiten kann es bei beheizten Komponenten 110, wie einer beheizten Fußbodenplatte, dazu kommen, dass ein Isolationswiderstand sinkt und ein Fehlerstrom 290 zwischen spannungsführenden Teilen des Heizerteiles und einer mit den Strukturanschlüssen 130 verbundenen Struktur auftritt. Dieser Fehlerstrom 290 führt zu einer Stromdifferenz in den Strömen des Hinleiters 120 und des Rückleiters 280. Dieser in der Regel kleine Fehlerstrom 290 kann aufgrund des einpoligen Anschlusses zwischen dem Heizercontroller und der beheizten Komponente 110 im Heizercontroller eventuell nicht ohne Weiteres erfasst werden und gegebenenfalls auch durch eine Ausgangsstrommessung mit dem Stromsensor im Heizercontroller unerkannt bleiben.

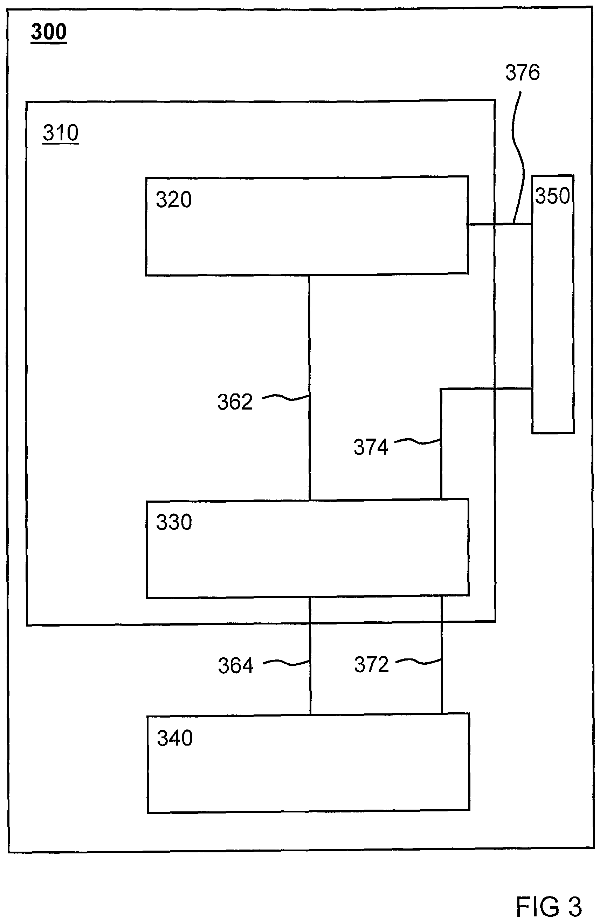

Fig. 3 zeigt eine schematische Darstellung eines Fahrzeugs 300 mit einer Fehlerstrom-Schutzeinrichtung 310 gemäß einem Ausführungsbeispiel der vorliegenden Erfindung. Die Fehlerstrom-Schutzeinrichtung 310 ist ausgebildet, um einen elektrischen Verbraucher des Fahrzeugs 300 auf einen Fehlerstrom zu überwachen.

Die Fehlerstrom-Schutzeinrichtung 310 weist dazu eine Steuervorrichtung 320 und einen Fehlerstromsensor 330 auf. Das Fahrzeug 300 weist die Fehlerstrom-Schutzeinrichtung 310, einen elektrischen Verbraucher 340 und eine geerdete, elektrisch leitende Struktur 350 bzw. ein geerdetes, elektrisch leitendes Strukturelement 350 des Fahrzeugs 300 auf. Die Steuervorrichtung 320 der Fehlerstrom-Schutzeinrichtung 310 ist ausgebildet, um den elektrischen Verbraucher 340 zu steuern. Der Fehlerstromsensor 330 ist elektrisch zwischen die Steuervorrichtung 320 und den elektrischen Verbraucher 340 geschaltet.

Die Steuervorrichtung 320, der Fehlerstromsensor 330 und der elektrische Verbraucher 340 sind gemäß dem in Fig. 3 dargestellten Ausführungsbeispiel der vorliegenden Erfindung mittels eines elektrischen Hinleiters und eines elektrischen Rückleiters miteinander elektrisch leitend verbunden. Hierbei weist der elektrische Hinleiter einen steuervorrichtungsseitigen Abschnitt 362 zwischen der Steuervorrichtung 320 und dem Fehlerstromsensor 330 sowie einen verbraucherseitigen Abschnitt 364 zwischen dem Fehlerstromsensor 330 und dem elektrischen Verbraucher 340 auf. Der elektrische Rückleiter weist einen verbraucherseitigen Abschnitt 372 zwischen dem elektrischen Verbraucher 340 und dem Fehlerstromsensor 330, einen strukturseitigen Abschnitt 374 zwischen dem Fehlerstromsensor 330 und der Fahrzeugstruktur 350 sowie einen weiteren strukturseitigen Abschnitt 376 zwischen der Fahrzeugstruktur 350 und der Steuervorrichtung 320 auf.

Somit erfolgt gemäß dem in Fig. 3 gezeigten und beschriebenen Ausführungsbeispiel der vorliegenden Erfindung Hinleitung elektrischen Stroms von der Steuervorrichtung 320 über den steuervorrichtungsseitigen Abschnitt 362 des Hinleiters, den Fehlerstromsensor 330 und den verbraucherseitigen Abschnitt 364 des Hinleiters zu dem elektrischen Verbraucher 340. Eine Rückleitung des elektrischen Stroms erfolgt hierbei von dem elektrischen Verbraucher 340 über den verbraucherseitigen Abschnitt 372 des Rückleiters, den Fehlerstromsensor 330, den strukturseitigen Abschnitt 374 des Rückleiters, die Fahrzeugstruktur 350 und den weiteren strukturseitigen Abschnitt 376 des Rückleiters zu der Steuer Vorrichtung 320. Die Fahrzeugstruktur 350 kann funktional als ein Teil des elektrischen Rückleiters betrachtet werden. Auch wenn es in Fig. 3 nicht explizit dargestellt ist, kann zumindest der Hinleiter als ein durchgängiger elektrischer Leiter ausgeführt sein.

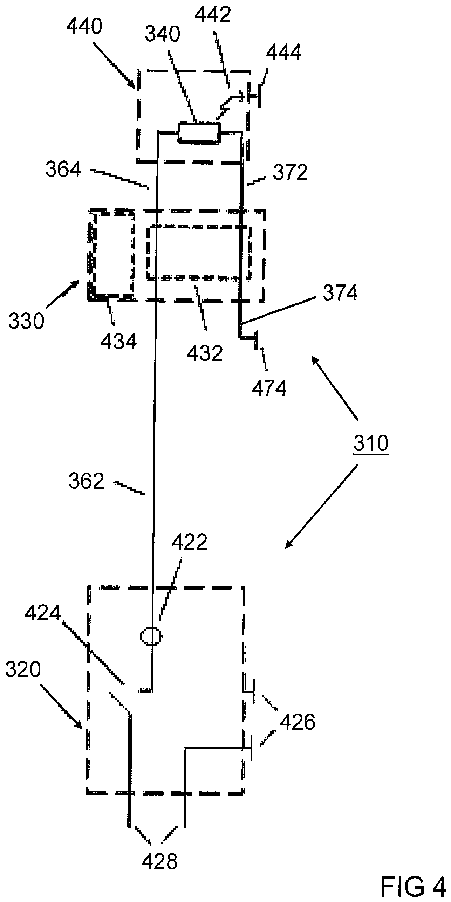

Fig. 4 zeigt eine schematische Darstellung einer Fehlerstrom-Schutzeinrichtung 310 gemäß einem Ausführungsbeispiel der vorliegenden Erfindung und eines elektrischen Verbrauchers 340 für ein Fahrzeug. Bei der Fehlerstrom-Schutzeinrichtung 310 handelt es sich um die Fehlerstrom-Schutzeinrichtung aus Fig. 3 oder eine ähnliche Fehlerstrom-Schutzeinrichtung. Somit ist die Fehlerstrom-Schutzeinrichtung 310 ausgebildet, um den elektrischen Verbraucher 340 zu überwachen. Die Fehlerstrom-Schutzeinrichtung 310 ist in dem Fahrzeug aus Fig. 3 oder einem ähnlichen Fahrzeug einsetzbar. Beispielsweise ist die Fehlerstrom-Schutzeinrichtung 310 in dem Fahrzeug aus Fig. 3 angeordnet.

Die Darstellung der Fehlerstrom-Schutzeinrichtung 310 in Fig. 4 entspricht prinzipiell der Darstellung der Fehlerstrom-Schutzeinrichtung aus Fig. 3 mit Ausnahme dessen, dass von der Steuervorrichtung 320 ferner ein Stromsensor 422, ein Ausgangsschalter 424, Strukturanschlüsse 426 sowie Versorgungsanschlüsse 428 gezeigt sind, dass von dem Fehlerstromsensor 330 ferner eine Messvorrichtung 432 und eine elektrische Schaltung 434 gezeigt sind, dass der elektrische Verbraucher 340 als ein Heizer oder Heizelement für eine beheizte Komponente 440 ausgeführt ist, dass ein symbolisch dargestellter Fehlerstrom 442 zu einem Komponenten-Strukturanschluss 444 der beheizten Komponente 440 gezeigt sind und dass ein Rückleiter-Strukturanschluss 474 gezeigt ist.

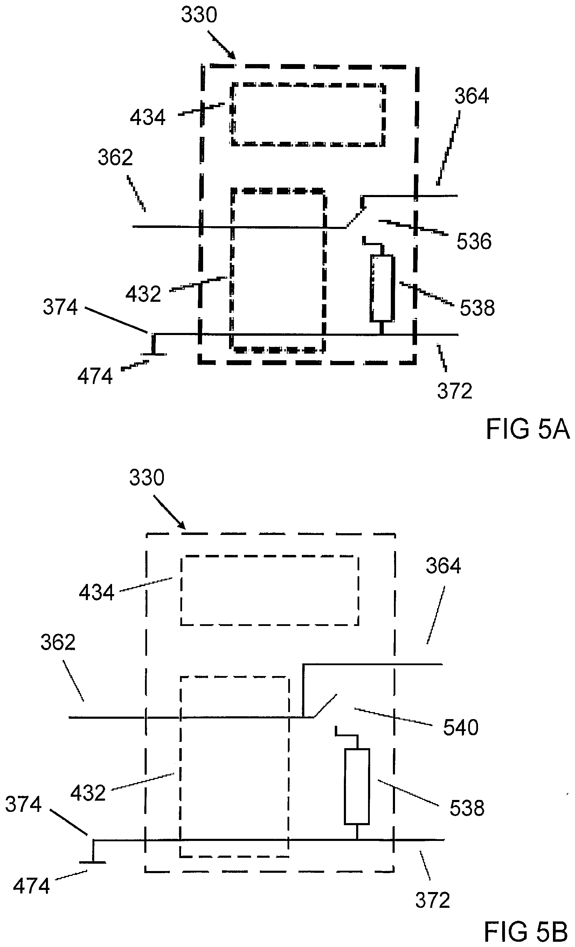

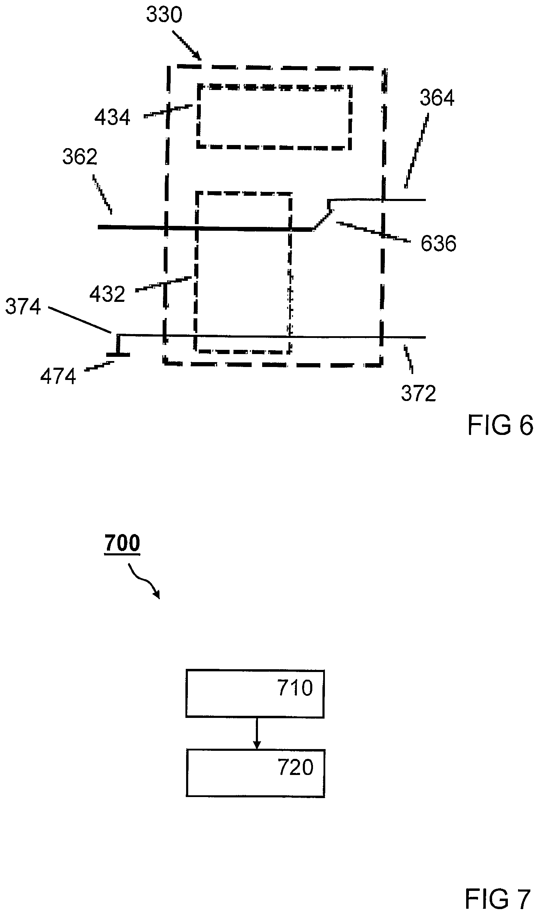

Der Fehlerstromsensor 330 weist gemäß dem in Fig. 4 dargestellten Ausführungsbeispiel der vorliegenden Erfindung die Messvorrichtung 432, die elektrische Schaltung 434 oder Elektronik 434 und eine Meldevorrichtung auf. Die Messvorrichtung 432 ist ausgebildet, um einen Differenzstrom zwischen einem ersten elektrischen Strom in dem elektrischen Hinleiter, der von der Steuervorrichtung 320 zum Steuern des elektrischen Verbrauchers 340 zu dem elektrischen Verbraucher 340 hinleitet, und einem zweiten elektrischen Strom in dem elektrischen Rückleiter zu messen, der von dem elektrischen Verbraucher 340 wegleitet. Die elektrische Schaltung 434 ist ausgebildet, um einen Vergleich des gemessenen Differenzstroms mit einem Schwellenwert durchzuführen. Die Meldevorrichtung des Fehlerstromsensors 330 ist ausgebildet, um abhängig von dem Vergleich des gemessenen Differenzstroms mit dem Schwellenwert den Fehlerstrom 442 an die Steuervorrichtung 320 über den Hinleiter zu melden. Auf die Meldevorrichtung, die in Fig. 4 lediglich aus Platzgründen in der Zeichnung weggelassen ist, wird nachfolgend und insbesondere unter Bezugnahme auf Fig. 5A, Fig. 5B bzw. Fig. 6 noch weiter eingegangen.

Gemäß einem Ausführungsbeispiel ist die Meldevorrichtung ausgebildet, um den Fehlerstrom 442 unter Verwendung einer Stromamplitudenmodulation auf dem Hinleiter, insbesondere dem steuervorrichtungsseitigen Abschnitt 362 des Hinleiters, an die Steuervorrichtung 320 zu melden. Gemäß einem anderen Ausführungsbeispiel ist die Meldevorrichtung ausgebildet, um den Fehlerstrom 442 durch Aufmodulieren eines hochfrequenten Datensignals auf den Hinleiter, insbesondere den steuervorrichtungsseitigen Abschnitt 362 des Hinleiters, an die Steuervorrichtung 320 zu melden.

Die Steuervorrichtung 320, die auch als ein Heizercontroller bezeichnet werden kann, weist gemäß dem in Fig. 4 dargestellten Ausführungsbeispiel der vorliegenden Erfindung den Stromsensor 422, den Ausgangsschalter 424, die Strukturanschlüsse 426 und die Versorgungsanschlüsse 428 auf. Dabei sind der Stromsensor 422 und der Ausgangsschalter 424 mit dem steuervorrichtungsseitigen Abschnitt 362 des Hinleiters verbunden, der auch als ein einpoliger elektrischer Anschluss bezeichnet werden kann. Der Stromsensor 422 ist ausgebildet, um einen elektrischen Strom in dem Hinleiter zu erfassen. Der Ausgangsschalter 424 ist ausgebildet, um einen elektrischen Stromfluss in dem Hinleiter zu unterbrechen. Die Steuervorrichtung 320 weist auch einen Ausgangsanschluss zum Anschluss an den steuervorrichtungsseitigen Abschnitt 362 des Hinleiters auf. Hierbei ist der Stromsensor 422 elektrisch zwischen den Ausgangsschalter 424 und den Ausgangsanschluss geschaltet. Mittels der Strukturanschlüsse 426 ist die Steuervorrichtung 320 an den strukturseitigen Abschnitt des Rückleiters oder direkt an das Strukturelement anschließbar. Zumindest einer der Strukturanschlüsse 426 repräsentiert dabei einen Eingangsanschluss zum Anschluss an den weiteren strukturseitigen Abschnitt des Rückleiters oder direkt an das Strukturelement. Über die Versorgungsanschlüsse 428 ist eine elektrische Spannung an den Hinleiter und den Rückleiter anlegbar. Anders ausgedrückt ist ein die Fehlerstrom-Schutzeinrichtung 310 und die beheizte Komponente 440 mit dem elektrischen Verbraucher 340 aufweisendes System über die Versorgungsanschlüsse 428 mit elektrischer Leistung versorgbar bzw. an eine elektrische Leistungsquelle anschließbar. Auch wenn es in Fig. 4 nicht explizit dargestellt ist, weist die Steuervorrichtung 320 gemäß dem in Fig. 4 gezeigten Ausführungsbeispiel der vorliegenden Erfindung eine elektrische Auswerteschaltung zum Auswerten des von dem Fehlerstromsensor 330 gemeldeten Fehlerstroms 442 auf. Zusätzlich oder alternativ weist die Steuervorrichtung 320 eine Empfangsschaltung zum Empfangen des von dem Fehlerstromsensor 330 gemeldeten Fehlerstroms 442 auf.

Die beheizte Komponente 440 weist den elektrischen Verbraucher 340 bzw. Heizer 340 und den Komponenten-Strukturanschluss 444 auf. Der Komponenten-Strukturanschluss 444 dient beispielsweise einer Erdung der beheizten Komponente 440. Über den Komponenten-Strukturanschluss 444 ist die beheizte Komponente 440 an eine Fahrzeugstruktur oder das Strukturelement des Fahrzeugs anschließbar.

Über den Rückleiter-Strukturanschluss 474 ist der strukturseitige Abschnitt 374 des Rückleiters an das Strukturelement des Fahrzeugs anschließbar. Optional kann hierbei der Rückleiter-Strukturanschluss 474 auch Teil des Fehlerstromsensors 330 sein. Dabei sind der strukturseitige Abschnitt 374 des Rückleiters und zumindest einer der Strukturanschlüsse 426 der Steuervorrichtung 320 über das Strukturelement des Fahrzeugs elektrisch leitend miteinander verbindbar oder verbunden.

Auch wenn es in Fig. 4 nicht explizit dargestellt ist, sind die Steuervorrichtung 320 und der Fehlerstromsensor 330 gemäß dem hier dargestellten Ausführungsbeispiel der vorliegenden Erfindung getrennt voneinander eingehaust. Anders ausgedrückt weist die Steuervorrichtung 320 ein erstes Gehäuse und der Fehlerstromsensor 330 ein separates zweites Gehäuse auf, die voneinander beabstandet oder getrennt angeordnet sind. Auch ist gemäß dem in Fig. 4 gezeigten Ausführungsbeispiel der vorliegenden Erfindung der steuervorrichtungsseitige Abschnitt 362 des Hinleiters zumindest so lang wie der verbraucherseitige Abschnitt 364 des Hinleiters. Dabei kann eine Länge des steuervorrichtungsseitigen Abschnitts 362 des Hinleiters lediglich beispielhaft etwa 1 Meter betragen.

Anders ausgedrückt kann unter Verwendung der Fehlerstrom-Schutzeinrichtung 310 der elektrischen Verbraucher 340 und/oder die beheizte Komponente 440 auf ein Auftreten eines Fehlerstromes 442 durch den bereits vorhandenen Heizercontroller 320 in Verbindung mit einem zum Heizercontroller 320 gehörigen, aber räumlich abgesetzten, Fehlerstromsensor 330 überwacht werden. Der Fehlerstromsensor 330 ist beispielsweise direkt an der zu überwachenden, beheizten Komponente 440 platziert und der Hin- und der Rückleiter zur beheizten Komponente 440 sind durch den Fehlerstromsensor 330 hindurchgeführt. Somit kann in dem Fehlerstromsensor 330 indirekt durch Vergleich des hin- und rückfließenden Stromes in den Hin- und den Rückleitern bzw. Komponentenanschlüssen ein Fehlerstrom erkannt, in der elektrischen Schaltung 434 bzw. Elektronik 434 bewertet und ab einem bestimmten Fehlerstromwert, z. B. 30 Milliampere oder dergleichen, eine Rückmeldung an die Steuervorrichtung 320 bzw. den Heizercontroller 320 gegeben werden. Die Steuervorrichtung 320 weist mit der Auswertevorrichtung eine technische Vorrichtung auf, die ausgebildet ist, um eine solche Rückmeldung auszuwerten und daraufhin die beheizte Komponente 440 über einen mechanischen oder elektronischen Ausgangsschalter 424 beispielsweise dauerhaft einpolig abzuschalten. Eine Energieversorgung des vom Heizercontroller 320 abgesetzten Fehlerstromsensors 330 ist aus einer Versorgungsspannung der zu überwachenden beheizten Komponente 440 abgeleitet oder ableitbar. Die Rückmeldung vom Fehlerstromsensor 330 an den Heizercontroller 320 erfolgt über den Hinleiter bzw. eine Versorgungsspannungsleitung für die beheizte Komponente 440, sodass insbesondere keine zusätzlichen elektrischen Verbindungen erforderlich werden. Beispielsweise führt der Fehlerstromsensor 330 keine permanente Abschaltung der überwachten beheizten Komponente 440 durch, sodass auch keine Rücksetzungssignale vom Heizungscontroller 320 an den Fehlerstromsensor 330 zu senden sind. Einen erkannten aufgetretenen Fehlerstrom 442 meldet der Fehlerstromsensor 330 dem Heizercontroller 320 über den Hinleiter bzw. die Versorgungsleitung vorzugsweise durch Veränderung einer Stromamplitude. Eine solche Veränderung bzw. Stromveränderung ist durch einen bereits im Heizercontroller 320 angeordneten Ausgangsstromsensor erfassbar und ist auswertbar, um die beheizte Komponente 440 abzuschalten.

Fig. 5A zeigt eine schematische Darstellung eines Fehlerstromsensors 330 für eine Fehlerstrom-Schutzeinrichtung gemäß einem Ausführungsbeispiel der vorliegenden Erfindung. Bei dem Fehlerstromsensor 330 handelt es sich hierbei um den Fehlerstromsensor der Fehlerstrom-Schutzeinrichtung aus Fig. 4 oder einen ähnlichen Fehlerstromsensor, wobei in Fig. 5A eine Ausführungsvariante der Meldevorrichtung des Fehlerstromsensors 330 genauer dargestellt ist.

In Fig. 5A sind der Fehlerstromsensor 330 mit der Messvorrichtung 432 und der elektrischen Schaltung 434, der steuervorrichtungsseitige Abschnitt 362 des Hinleiters, der verbraucherseitige Abschnitt 364 des Hinleiters, der verbraucherseitige Abschnitt 372 des Rückleiters, der strukturseitige Abschnitt 374 des Rückleiters, der Rückleiter-Strukturanschluss 474 sowie ferner die Meldevorrichtung des Fehlerstromsensors 330 mit einem Lastumschalter 536 oder Stromumschalter 536 und einer definierten Last 538 dargestellt.

Somit weist der Fehlerstromsensor 330 die Messvorrichtung 432, die elektrische Schaltung 434 und die Meldevorrichtung auf, die den Lastumschalter 536 und die definierte Last 538 aufweist. Anders ausgedrückt weist gemäß dem in Fig. 5A dargestellten Ausführungsbeispiel der vorliegenden Erfindung die Meldevorrichtung des Fehlerstromsensors 330 den Lastumschalter 536 bzw. Schalter 536 zum Lastumschalten und die definierte Last 538 auf. Die definierte Last 538 ist elektrisch mit dem Rückleiter verbunden bzw. zwischen einen Anschluss des Lastumschalters 536 und den Rückleiter geschaltet. Der Lastumschalter 536 ist ausgebildet, um in einer geöffneten Schaltstellung den Hinleiter zu dem elektrischen Verbraucher zu unterbrechen und mit der definierten Last 538 zu verbinden.

Gemäß einem Ausführungsbeispiel weist der Fehlerstromsensor 330 einen Hinleiter-Eingangsanschluss zum Anschluss an den steuervorrichtungsseitigen Abschnitt 362 des Hinleiters, einen Hinleiter-Ausgangsanschluss zum Anschluss an den verbraucherseitigen Abschnitt 364 des Hinleiters, einen Rückleiter-Eingangsanschluss zum Anschluss an den verbraucherseitigen Abschnitt 372 des Rückleiters und einen Rückleiter-Ausgangsanschluss zum Anschluss an den strukturseitigen Abschnitt 374 des Rückleiters auf.

Zum Melden eines Fehlerstroms wird beispielsweise eine Stromveränderung mittels des Lastumschalters 536, der als ein mechanischer oder elektronischer Schalter ausgeführt sein kann, im Fehlerstromsensor 330 dadurch erzeugt, dass der Strom zur beheizten Komponente abgeschaltet und die im Fehlerstromsensor 330 angeordnete definierte Last 538 eingeschaltet wird. Der Strom der definierten Last 538 liegt unterhalb eines Bereiches, den die beheizte Komponente als Versorgungsstrom zieht, und ist durch eine Strommessung im Heizercontroller als Auftreten eines Fehlerstromes interpretierbar. Die Stromumschaltung auf die definierte Last 538 führt insbesondere zu einer zuverlässigen Fehlerarterkennung durch den Heizercontroller und kann entsprechend als erkannter Fehlerstrom bewertet werden. Vorteilhaft hieran ist auch, dass der Stromsensor zur Ausgangsstromerfassung und der Ausgangsschalter bereits im Heizercontroller implementiert oder angeordnet sind und beispielsweise lediglich eine zusätzliche Strominformationsauswertung im Heizercontroller vorzusehen ist, sofern ein Fehler als erkannter Fehlerstrom gemeldet werden soll.

Fig. 5B zeigt eine schematische Darstellung eines Fehlerstromsensors 330 für eine Fehlerstrom-Schutzeinrichtung gemäß einem Ausführungsbeispiel der vorliegenden Erfindung. Bei dem Fehlerstromsensor 330 handelt es sich hierbei um den Fehlerstromsensor der Fehlerstrom-Schutzeinrichtung aus Fig. 4 oder einen ähnlichen Fehlerstromsensor, wobei in Fig. 5B eine weitere Ausführungsvariante der Meldevorrichtung des Fehlerstromsensors 330 genauer dargestellt ist. Mit Ausnahme der Meldevorrichtung entspricht der Fehlerstromsensor 330 in Fig. 5B dabei dem Fehlerstromsensor aus Fig. 5A. Die Meldevorrichtung des Fehlerstromsensors 330 weist einen Lastzuschalter 540 Schalter 540 zum Lastzuschalten auf. Der Lastzuschalter 540 ist ausgebildet, um in einer geschlossenen Schaltstellung die definierte Last 538 mit dem Hinleiter 362, 364 zu verbinden. Bei dieser Variante erfolgt keine Abschaltung der beheizten Komponente durch den Lastzuschalter 540.

Fig. 6 zeigt eine schematische Darstellung eines Fehlerstromsensors 330 für eine Fehlerstrom-Schutzeinrichtung gemäß einem Ausführungsbeispiel der vorliegenden Erfindung. Bei dem Fehlerstromsensor 330 handelt es sich hierbei um den Fehlerstromsensor der Fehlerstrom-Schutzeinrichtung aus Fig. 4 oder einen ähnlichen Fehlerstromsensor, wobei in Fig. 6 eine weitere Ausführungsvariante der Meldevorrichtung des Fehlerstromsensors 330 genauer dargestellt ist. Mit Ausnahme der Meldevorrichtung entspricht der Fehlerstromsensor 330 in Fig. 6 ferner dem Fehlerstromsensor aus Fig. 5A bzw. Fig. 5B.

Hierbei weist die Meldevorrichtung des Fehlerstromsensors 330 einen Lastabschalter 636 bzw. Stromabschalter 636 bzw. Schalter zum Lastabschalten auf. Der Lastabschalter 636 ist ausgebildet, um in einer geöffneten Schaltstellung den Hinleiter zu dem elektrischen Verbraucher zu unterbrechen.

Bei dieser Variante erfolgt eine Abschaltung der beheizten Komponente durch den Lastabschalter 636, der beispielsweise als ein mechanischer oder elektronischer Schalter ausgeführt ist, im Fehlerstromsensor 330, welches wiederum zum Abschalten durch den Heizercontroller führt, da dann ein Laststrom außerhalb des definierten Bereiches auftritt, Vorteilhaft hieran ist auch, dass der Stromsensor zur Ausgangsstromerfassung und der Ausgangsschalter bereits im Heizercontroller implementiert oder angeordnet sind und beispielsweise lediglich eine zusätzliche Strominformationsauswertung im Heizercontroller vorzusehen ist, sofern ein Fehler als erkannter Fehlerstrom gemeldet werden soll.

Fig. 7 zeigt ein Ablaufdiagramm eines Verfahrens 700 zum Bestimmen gemäß einem Ausführungsbeispiel der vorliegenden Erfindung. Das Verfahren 700 ist ausführbar, um einen Fehlerstrom eines elektrischen Verbrauchers für ein Fahrzeug zu bestimmen. Hierbei ist das Verfahren 700 zum Bestimmen in Verbindung mit oder unter Verwendung von dem Fehlerstromsensor aus einer der Figuren 3 bis 6 oder einem ähnlichen Fehlerstromsensor bzw. in Verbindung mit oder unter Verwendung von einer Fehlerstrom-Schutzeinrichtung aus einer der Figuren 3 bis 4 oder einer ähnlichen Fehlerstrom-Schutzeinrichtung ausführbar.

Das Verfahren 700 zum Bestimmen weist gemäß dem in Fig. 7 dargestellten Ausführungsbeispiel der vorliegenden Erfindung einen Schritt 710 des Messens und einen Schritt 720 des Meldens auf. Dabei wird in dem Schritt 710 des Messens ein Differenzstrom zwischen einem ersten elektrischen Strom in einem elektrischen Hinleiter, der von einer Steuervorrichtung zum Steuern des elektrischen Verbrauchers zu dem elektrischen Verbraucher hinleitet, und einem zweiten elektrischen Strom in einem elektrischen Rückleiter gemessen, der von dem elektrischen Verbraucher wegleitet. In dem Schritt 720 des Meldens wird abhängig von einem Vergleich des gemessenen Differenzstroms mit einem Schwellenwert ein Fehlerstrom über den Hinleiter an die Steuervorrichtung gemeldet.

Gemäß einem Ausführungsbeispiel kann einem Verfahren 700 auch zwischen dem Schritt 710 des Messens und dem Schritt 720 des Meldens ein Schritt des Vergleichens des gemessenen Differenzstroms mit einem Schwellenwert durchgeführt werden, um ein Vorliegen eines Fehlerstroms zu erkennen oder zu ermitteln.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden. Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

### Bezugszeichen liste

- 100: Heizersteuervorrichtung bzw. Heizercontroller
- 110: beheizte Komponente
- 130: Strukturanschluss bzw. Anschluss über eine Struktur
- 140: Versorgungsanschlüsse
- 150: Stromsensor
- 160: Ausgangsschalter
- 170: Heizer
- 280: Rückleiter
- 290: Fehlerstrom
- 300: Fahrzeug
- 310: Fehlerstrom-Schutzeinrichtung
- 320: Steuervorrichtung
- 330: Fehlerstromsensor
- 340: elektrischen Verbraucher
- 350: Strukturelement
- 362: steuervorrichtungsseitiger Abschnitt des Hinleiters
- 364: verbraucherseitiger Abschnitt des Hinleiters
- 372: verbraucherseitiger Abschnitt des Rückleiters
- 374: strukturseitiger Abschnitt des Rückleiters
- 376: weiterer strukturseitiger Abschnitt des Rückleiters
- 422: Stromsensor
- 424: Ausgangsschalter
- 426: Strukturanschlüsse
- 428: Versorgungsanschlüsse
- 432: Messvorrichtung
- 434: elektrische Schaltung
- 440: beheizte Komponente
- 442: Fehlerstrom
- 444: Komponenten-Strukturanschluss
- 474: Rückleiter-Strukturanschluss
- 536: Lastumschalter bzw. Stromumschalter
- 538: definierte Last
- 540: Lastzuschalter
- 636: Lastabschalter bzw. Stromabschalter
- 700: Verfahren zum Bestimmen
- 710: Schritt des Messens
- 720: Schritt des Meldens

## Patentansprüche

1. Fehlerstromsensor (330) für eine Fehlerstrom-Schutzeinrichtung (310) zum Überwachen eines elektrischen Verbrauchers (340) für ein Fahrzeug (300), wobei der Fehlerstromsensor (330) folgende Merkmale aufweist:
eine Messvorrichtung (432) zum Messen eines Differenzstroms zwischen einem ersten elektrischen Strom in einem elektrischen Hinleiter (362, 364), der von einer Steuervorrichtung (320) zum Steuern des elektrischen Verbrauchers (340) zu dem elektrischen Verbraucher (340) hinleitet, und einem zweiten elektrischen Strom in einem elektrischen Rückleiter (372, 374, 376), der von dem elektrischen Verbraucher (340) wegleitet; und
eine Meldevorrichtung (536, 538; 636) zum Melden eines Fehlerstroms (442) an die Steuervorrichtung (320) über den Hinleiter (362, 364) abhängig von einem Vergleich des gemessenen Differenzstroms mit einem Schwellenwert, **dadurch gekennzeichnet, dass** die Meldevorrichtung einen Schalter (536) zum Lastumschalten und eine definierte Last (538) aufweist, wobei die definierte Last (538) mit dem Rückleiter (372, 374, 376) elektrisch leitend verbunden ist, wobei der Schalter (536) ausgebildet ist, um in einer geöffneten Schaltstellung den Hinleiter (362, 364) zu unterbrechen und mit der definierten Last (538) zu verbinden.

2. Fehlerstromsensor (330) für eine Fehlerstrom-Schutzeinrichtung (310) zum Überwachen eines elektrischen Verbrauchers (340) für ein Fahrzeug (300), wobei der Fehlerstromsensor (330) folgende Merkmale aufweist:
eine Messvorrichtung (432) zum Messen eines Differenzstroms zwischen einem ersten elektrischen Strom in einem elektrischen Hinleiter (362, 364), der von einer Steuervorrichtung (320) zum Steuern des elektrischen Verbrauchers (340) zu dem elektrischen Verbraucher (340) hinleitet, und einem zweiten elektrischen Strom in einem elektrischen Rückleiter (372, 374, 376), der von dem elektrischen Verbraucher (340) wegleitet; und
eine Meldevorrichtung (536, 538; 636) zum Melden eines Fehlerstroms (442) an die Steuervorrichtung (320) über den Hinleiter (362, 364) abhängig von einem Vergleich des gemessenen Differenzstroms mit einem Schwellenwert, **dadurch gekennzeichnet, dass** die Meldevorrichtung einen Schalter (540) zum Zuschalten einer definierten Last (538) aufweist, wobei die definierte Last (538) mit dem Rückleiter (372, 374, 376) elektrisch leitend verbunden ist, wobei der Schalter (540) ausgebildet ist, um in einer geschlossenen Schaltstellung die definierte Last (538) mit dem Hinleiter (362, 364) zu verbinden.

3. Fehlerstromsensor (330) gemäß einem der vorangegangenen Ansprüche, bei dem die Meldevorrichtung (536, 538; 636) ausgebildet ist, um den Fehlerstrom (442) unter Verwendung einer Stromamplitudenmodulation auf dem Hinleiter (362, 364) an die Steuervorrichtung (320) zu melden.

4. Fehlerstromsensor (330) gemäß einem der vorangegangenen Ansprüche, bei dem die Meldevorrichtung einen Schalter (636) zum Lastabschalten aufweist, wobei der Schalter (636) ausgebildet ist, um in einer geöffneten Schaltstellung den Hinleiter (362, 364) zu unterbrechen.

5. Fehlerstromsensor (330) gemäß einem der vorangegangenen Ansprüche, bei dem die Meldevorrichtung (536, 538; 636) ausgebildet ist, um den Fehlerstrom (442) durch Aufmodulieren eines hochfrequenten Datensignals auf den Hinleiter (362, 364) an die Steuervorrichtung (320) zu melden.

6. Fehlerstromsensor (330) gemäß einem der vorangegangenen Ansprüche, der eine elektrische Schaltung (434) zum Durchführen des Vergleichs des gemessenen Differenzstroms mit einem Schwellenwert aufweist.

7. Fehlerstrom-Schutzeinrichtung (310) zum Überwachen eines elektrischen Verbrauchers (340) für ein Fahrzeug (300), wobei die Fehlerstrom-Schutzeinrichtung (310) folgende Merkmale aufweist:
einen Fehlerstromsensor (330) gemäß einem der vorangegangenen Ansprüche; und
eine Steuervorrichtung (320) zum Steuern des elektrischen Verbrauchers (340), wobei die Steuervorrichtung (320) und der Fehlerstromsensor (330) zumindest mittels des Hinleiters (362, 364) miteinander elektrisch leitend verbindbar oder verbunden sind.

8. Fehlerstrom-Schutzeinrichtung (310) gemäß Anspruch 7, bei der die Steuervorrichtung (320) und der Fehlerstromsensor (330) getrennt voneinander eingehaust sind.

9. Fehlerstrom-Schutzeinrichtung (310) gemäß einem der Ansprüche 7 bis 8, wobei der Fehlerstromsensor (330) einen Hinleiter-Eingangsanschluss zum Anschluss an einen steuervorrichtungsseitigen Abschnitt (362) des Hinleiters, einen Hinleiter-Ausgangsanschluss zum Anschluss an einen verbraucherseitigen Abschnitt (364) des Hinleiters, einen Rückleiter-Eingangsanschluss zum Anschluss an einen verbraucherseitigen Abschnitt (372) des Rückleiters und einen Rückleiter-Ausgangsanschluss zum Anschluss an einen strukturseitigen Abschnitt (374) des Rückleiters aufweist.

10. Fehlerstrom-Schutzeinrichtung (310) gemäß Anspruch 9, wobei der steuervorrichtungsseitige Abschnitt (362) des Hinleiters zumindest so lang ist wie der verbraucherseitige Abschnitt (364) des Hinleiters.

11. Fehlerstrom-Schutzeinrichtung (310) gemäß einem der Ansprüche 9 bis 10, bei der die Steuervorrichtung (320) zumindest einen Ausgangsanschluss zum Anschluss an den steuervorrichtungsseitigen Abschnitt (362) des Hinleiters und einen Eingangsanschluss (426) zum Anschluss an einen weiteren strukturseitigen Abschnitt (376) des Rückleiters aufweist, wobei der weitere strukturseitige Abschnitt (376) und der strukturseitige Abschnitt (374) des Rückleiters über ein Strukturelement (350) des Fahrzeugs (300) elektrisch leitend miteinander verbindbar oder verbunden sind.

12. Fehlerstrom-Schutzeinrichtung (310) gemäß einem der Ansprüche 7 bis 11, bei der die Steuervorrichtung (320) eine elektrische Auswerteschaltung zum Auswerten des von dem Fehlerstromsensor (330) gemeldeten Fehlerstroms (442) aufweist.

## Claims

1. Fault current sensor (330) for a fault current protective device (310) for monitoring an electrical consumer (340) for a vehicle (300), wherein the fault current sensor (330) has the following features:
a measuring device (432) for measuring a differential current between a first electrical current in an electrical supply conductor (362, 364), which leads from a control device (320) for controlling the electrical consumer (340) to the electrical consumer (340), and a second electrical current in an electrical return conductor (372, 374, 376), which leads away from the electrical consumer (340); and
a signalling device (536, 538; 636) for signalling a fault current (442) to the control device (320) via the supply conductor (362, 364) on the basis of a comparison of the measured differential current with a threshold value, **characterized in that** the signalling device has a switch (536) for load switching and a defined load (538), wherein the defined load (538) is connected to the return conductor (372, 374, 376) in an electrically conductive manner, wherein the switch (536) is designed, in an open switching position, to interrupt the supply conductor (362, 364) and to connect it to the defined load (538).

2. Fault current sensor (330) for a fault current protective device (310) for monitoring an electrical consumer (340) for a vehicle (300), wherein the fault current sensor (330) has the following features:
a measuring device (432) for measuring a differential current between a first electrical current in an electrical supply conductor (362, 364), which leads from a control device (320) for controlling the electrical consumer (340) to the electrical consumer (340), and a second electrical current in an electrical return conductor (372, 374, 376), which leads away from the electrical consumer (340); and
a signalling device (536, 538; 636) for signalling a fault current (442) to the control device (320) via the supply conductor (362, 364) on the basis of a comparison of the measured differential current with a threshold value, **characterized in that** the signalling device has a switch (540) for connecting a defined load (538), wherein the defined load (538) is connected to the return conductor (372, 374, 376) in an electrically conductive manner, wherein the switch (540) is designed to connect the defined load (538) to the supply conductor (362, 364) in a closed switching position.

3. Fault current sensor (330) according to one of the preceding claims, in which the signalling device (536, 538; 636) is designed to signal the fault current (442) to the control device (320) using current amplitude modulation on the supply conductor (362, 364).

4. Fault current sensor (330) according to one of the preceding claims, in which the signalling device has a switch (636) for load disconnection, wherein the switch (636) is designed to interrupt the supply conductor (362, 364) in an open switching position.

5. Fault current sensor (330) according to one of the preceding claims, in which the signalling device (536, 538; 636) is designed to signal the fault current (442) to the control device (320) by modulating a high-frequency data signal onto the supply conductor (362, 364).

6. Fault current sensor (330) according to one of the preceding claims, which has an electrical circuit (434) for comparing the measured differential current with a threshold value.

7. Fault current protective device (310) for monitoring an electrical consumer (340) for a vehicle (300), wherein the fault current protective device (310) has the following features:
a fault current sensor (330) according to one of the preceding claims; and
a control device (320) for controlling the electrical consumer (340), wherein the control device (320) and the fault current sensor (330) can be connected or are connected to one another in an electrically conductive manner at least by means of the supply conductor (362, 364).

8. Fault current protective device (310) according to Claim 7, in which the control device (320) and the fault current sensor (330) are encased separately from one another.

9. Fault current protective device (310) according to one of Claims 7 to 8, wherein the fault current sensor (330) has a supply conductor input connection for connection to a section (362) of the supply conductor on the control device side, a supply conductor output connection for connection to a section (364) of the supply conductor on the consumer side, a return conductor input connection for connection to a section (372) of the return conductor on the consumer side, and a return conductor output connection for connection to a section (374) of the return conductor on the structure side.

10. Fault current protective device (310) according to Claim 9, wherein the section (362) of the supply conductor on the control device side is at least as long as the section (364) of the supply conductor on the consumer side.

11. Fault current protective device (310) according to one of Claims 9 to 10, in which the control device (320) has at least one output connection for connection to the section (362) of the supply conductor on the control device side and an input connection (426) for connection to a further section (376) of the return conductor on the structure side, wherein the further section (376) on the structure side and the section (374) of the return conductor on the structure side can be connected or are connected to one another in an electrically conductive manner via a structural element (350) of the vehicle (300).

12. Fault current protective device (310) according to one of Claims 7 to 11, in which the control device (320) has an electrical evaluation circuit for evaluating the fault current (442) signalled by the fault current sensor (330).

## Revendications

1. Détecteur de courant de fuite (330) pour un dispositif de protection contre les courants de fuite (310) destiné à la surveillance d'un récepteur électrique (340) pour un véhicule (300), le détecteur de courant de fuite (330) possédant les caractéristiques suivantes :
un arrangement de mesure (432) destiné à mesurer un courant différentiel entre un premier courant électrique dans un conducteur d'arrivée électrique (362, 364), qui le conduit d'un arrangement de commande (320) destiné à commander le récepteur électrique (340) vers le récepteur électrique (340), et un deuxième courant électrique dans un conducteur de retour électrique (372, 374, 376), qui le conduit à l'écart du récepteur électrique (340) ; et
un arrangement de signalisation (536, 538 ; 636) destiné à signaler un courant de fuite (442) à l'arrangement de commande (320) par le biais du conducteur d'arrivée (362, 364) en fonction d'une comparaison du courant différentiel mesuré avec une valeur de seuil, **caractérisé en ce que** l'arrangement de signalisation possède un commutateur (536) servant à la permutation de charge et une charge définie (538), la charge définie (538) étant reliée de manière électriquement conductrice au conducteur de retour (372, 374, 376), le commutateur (536) étant configuré pour, dans une position de commutation ouverte, interrompre le conducteur d'arrivée (362, 364) et le relier à la charge définie (538).

2. Détecteur de courant de fuite (330) pour un dispositif de protection contre les courants de fuite (310) destiné à la surveillance d'un récepteur électrique (340) pour un véhicule (300), le détecteur de courant de fuite (330) possédant les caractéristiques suivantes :
un arrangement de mesure (432) destiné à mesurer un courant différentiel entre un premier courant électrique dans un conducteur d'arrivée électrique (362, 364), qui le conduit d'un arrangement de commande (320) destiné à commander le récepteur électrique (340) vers le récepteur électrique (340), et un deuxième courant électrique dans un conducteur de retour électrique (372, 374, 376), qui le conduit à l'écart du récepteur électrique (340) ; et
un arrangement de signalisation (536, 538 ; 636) destiné à signaler un courant de fuite (442) à l'arrangement de commande (320) par le biais du conducteur d'arrivée (362, 364) en fonction d'une comparaison du courant différentiel mesuré avec une valeur de seuil, **caractérisé en ce que** l'arrangement de signalisation possède un commutateur (540) servant à la mise en circuit d'une charge définie (538), la charge définie (538) étant reliée de manière électriquement conductrice au conducteur de retour (372, 374, 376), le commutateur (540) étant configuré pour, dans une position de commutation fermée, relier la charge définie (538) au conducteur d'arrivée (362, 364).

3. Détecteur de courant de fuite (330) selon l'une des revendications précédentes, avec lequel l'arrangement de signalisation (536, 538 ; 636) est configuré pour signaler le courant de fuite (442) à l'arrangement de commande (320) en utilisant une modulation d'amplitude de courant sur le conducteur d'arrivée (362, 364).

4. Détecteur de courant de fuite (330) selon l'une des revendications précédentes, avec lequel l'arrangement de signalisation possède un commutateur (636) servant à la mise hors circuit de charge, le commutateur (636) étant configuré pour, dans une position de commutation ouverte, interrompre le conducteur d'arrivée (362, 364).

5. Détecteur de courant de fuite (330) selon l'une des revendications précédentes, avec lequel l'arrangement de signalisation (536, 538 ; 636) est configuré pour signaler le courant de fuite (442) à l'arrangement de commande (320) par surmodulation d'un signal de données à haute fréquence sur le conducteur d'arrivée (362, 364).

6. Détecteur de courant de fuite (330) selon l'une des revendications précédentes, lequel possède un circuit électrique (434) destiné à réaliser la comparaison du courant différentiel mesuré avec une valeur de seuil.

7. Dispositif de protection contre les courants de fuite (310) destiné à la surveillance d'un récepteur électrique (340) pour un véhicule (300), le dispositif de protection contre les courants de fuite (310) possédant les caractéristiques suivantes :
un détecteur de courant de fuite (330) selon l'une des revendications précédentes ; et
un arrangement de commande (320) destiné à commander le récepteur électrique (340), l'arrangement de commande (320) et le détecteur de courant de fuite (330) pouvant être reliés ou étant reliés de manière électriquement conductrice l'un à l'autre au moins au moyen du conducteur d'arrivée (362, 364).

8. Dispositif de protection contre les courants de fuite (310) selon la revendication 7, avec lequel l'arrangement de commande (320) et le détecteur de courant de fuite (330) sont logés séparément l'un de l'autre.

9. Dispositif de protection contre les courants de fuite (310) selon l'une des revendications 7 et 8, le détecteur de courant de fuite (330) possédant une borne d'entrée de conducteur d'arrivée servant au raccordement à une portion côté arrangement de commande (362) du conducteur d'arrivée, une borne de sortie de conducteur d'arrivée servant au raccordement à une portion côté récepteur (364) du conducteur d'arrivée, une borne d'entrée de conducteur de retour servant au raccordement à une portion côté récepteur (372) du conducteur de retour et une borne de sortie de conducteur de retour servant au raccordement à une portion côté structure (374) du conducteur de retour.

10. Dispositif de protection contre les courants de fuite (310) selon la revendication 9, la portion côté arrangement de commande (362) du conducteur d'arrivée étant au moins aussi longue que la portion côté récepteur (364) du conducteur d'arrivée.

11. Dispositif de protection contre les courants de fuite (310) selon l'une des revendications 9 et 10, avec lequel l'arrangement de commande (320) possède au moins une borne de sortie servant au raccordement à la portion côté arrangement de commande (362) du conducteur d'arrivée et une borne d'entrée (426) servant au raccordement à une portion côté structure supplémentaire (376) du conducteur de retour, la portion côté structure supplémentaire (376) et la portion côté structure (374) du conducteur de retour pouvant être reliées ou étant reliées de manière électriquement conductrice l'une à l'autre par le biais d'un élément structurel (350) du véhicule (300).

12. Dispositif de protection contre les courants de fuite (310) selon l'une des revendications 7 à 11, avec lequel l'arrangement de commande (320) possède un circuit d'interprétation électrique destiné à interpréter le courant de fuite (442) signalé par le détecteur de courant de fuite (330).
